# EUROPEAN PATENT APPLICATION

(11) **EP 3 073 109 A1**
(43) Date of publication of application: **28.09.2016**
(21) Application number: 15382135.0
(22) Date of filing: 23.03.2015
(51) Int. Cl.: F03D 7/04, F03D 13/00, F03D 15/00, G05B 17/02

(54) **OBTAINING DYNAMIC PROPERTIES OF A PART OF WIND TURBINE**

(71) Applicant: ALSTOM Renewable Technologies, 38100 Grenoble (FR)
(72) Inventor: Bergua, Roger, 08017 BARCELONA (ES); Jové, Jordi, 08018 BARCELONA (ES)
(74) Representative: ZBM Patents - Zea, Barlocci & Markvardsen

(57) **Abstract**

A method for determining one or more dynamic properties of a part of a wind turbine comprises the converter sending an input signal to the generator to create an input load, measuring a response from the part under the input load with one or more sensors, and determining one or more dynamic properties of the part from the response and the input load. Also disclosed are methods for determining a fault and for generating a fault register.

## Description

The present disclosure relates to methods and systems for obtaining the dynamic properties of a part of a wind turbine.

### BACKGROUND

Modern wind turbines are commonly used to supply electricity into the electrical grid. Wind turbines of this kind generally comprise a rotor with a plurality of blades. The rotor with the blades is set into rotation under the influence of the wind on the blades. The rotation of the rotor shaft drives the generator rotor either directly ("directly driven") or through the use of a gearbox.

The combination of rotor, rotor shaft (if present), gearbox (if present) and generator is usually referred to as the "drive train" of a wind turbine. In a direct drive wind turbine, the drive train may thus consist only of the rotor, the generator and some form of coupling means between the rotor and the generator. And in the case of wind turbines with a gearbox, the drive train may include the rotor, possibly a rotor shaft, a gearbox and the generator.

Various types of generators are further known for use in wind turbines. For example, the use of Squirrel Cage Induction Generators (SCIG) is known and has been widely used in the past. SCIG are induction generators comprising essentially a cylindrical laminated rotor core with longitudinal conductive bars. Additionally, wound rotor induction generators (WRIG), especially when used in the form of doubly-fed induction generators (DFIG), are also widely applied in modern wind turbines. Other types of induction generators are also known.

Synchronous electrical generators are also known. For example, the use of Wound Rotor Synchronous Generators (WRSG) is known. In WRSG, electromagnets, usually fed with a DC source, are arranged on the rotor surface to generate a magnetic field.

Permanent Magnet Synchronous Generators (PMSG) having a rotor carrying permanent magnets to generate the magnetic field can be used in wind turbines. They are generally deemed to be reliable and require less maintenance than other generator topologies. For offshore wind turbines, direct drive systems employing permanent magnets are generally regarded as preferable. However, the use of permanent magnet generators is not limited to these kinds of applications.

It is important to know the dynamic properties of the wind turbine. Under certain loads and operational conditions, a danger of resonance may exist. With appropriate control, some of those risks can be avoided or reduced. However, appropriate control can only be carried out if the assumptions that the control is based upon are correct, i.e. if the wind turbine in fact behaves in the way it was designed or calculated or predicted to behave.

Full scale testing that involves measuring the dynamic response of a target structure to excitation which is typically applied in different ways is therefore preferable.

The simplest approach would be to employ ambient excitation, typically from wind. The drawback is the almost complete lack of control over the timing, duration, amplitude and direction of the applied effects. Furthermore, it is also known to use specific events, such as an emergency stop (or torque release), to characterize the dynamic response of wind turbines comprising a gearbox (geared wind turbines). Unfortunately, those specific events are generally only capable of exciting low frequency modes whereas some wind turbines, and in particular some types of direct drive wind turbines exhibit relevant vibration modes at significantly higher frequencies.

The currently preferred method is therefore forced vibration testing using a mechanical exciter to apply a harmonically varying force of known frequency and amplitude to the structure, in particular the drive train. Such testing can be carried out e.g. in a manufacturing or assembly facility.

Modal testing is a form of vibration testing of an object whereby the natural (modal) frequencies, modal masses, modal damping ratios and mode shapes of the object under test are determined. A modal test consists of an acquisition phase and an analysis phase. The complete process is often referred to as a Modal Analysis or Experimental Modal Analysis, which can thus be defined as the study of the dynamic properties of structures under vibrational excitation.

There are currently several ways to do modal testing but impact hammer testing and shaker (vibration tester) testing are the most common ones. In both cases energy is supplied to the system with a known frequency content. Where structural resonances occur there will be an amplification of the response, clearly seen in the response spectra.

Modern day modal analysis systems are composed of 1) Sensors such as transducers (typically accelerometers, load cells), or non-contact sensors via e.g. a laser vibrometer, 2) data acquisition system and an analog-to-digital converter, and 3) host PC to view the data and process it.

Typical excitation signals can be classed as impulse, broadband, steady-state sinusoidal, swept sine, chirp, random and possibly others such as square, sawtooth or triangle. The analysis of the signals typically relies on Fourier analysis. The resulting transfer function will show one or more resonances, whose characteristic mass, frequency and damping can be estimated from the measurements.

Usually, Experimental Modal Analysis (EMA) is performed over different parts of a wind turbine to determine its dynamic properties.

In large direct drive wind turbines and particularly those involving permanent magnet generators, hammer tests are difficult to accomplish regarding the drivetrain for several reasons. It is very hard to reproduce a real-life situation in a test, and the high frequencies and energies needed are hard to achieve using conventional methods.

An alternative may be using multiple shakers leading to a uniform distribution of the energy over the entire structure and a better coherence in the measurement. A shaker is a device that excites the object or structure according to its amplified input signal. However, time and added costs are required for the shakers to be temporally installed in the system, and their presence can influence the dynamic properties of the structure and can also increase the complexity of analysis.

In examples of the present disclosure, at least some of the aforementioned problems are at least partially resolved.

### SUMMARY

According to a first aspect, a method for determining one or more dynamic properties of a part of a wind turbine is provided. The wind turbine includes a wind turbine rotor with a rotor hub and one or more blades, a generator operatively coupled to the rotor, and a converter connected to the generator. In accordance with this aspect, the method comprises the converter sending an input signal to the generator to create an input load, measuring a response from the part of the wind turbine under the input load with one or more sensors, and determining one or more dynamic properties of the part of the wind turbine from the response and the input load.

In examples according to this first aspect, instead of addressing the problem by means that are external to the wind turbine, the problem may be addressed by means inherent to the turbine, namely the converter. In accordance with this first aspect, the converter may provide the excitation needed to induce an input load, appropriate sensors can be used to measure the response in terms of movements (vibrations) and loads. Since the input load is known and the output is known, relatively simple, cheap and effective methods for determining these properties are provided.

Throughout the present disclosure, a part of a wind turbine may refer to a single component (e.g. tower or blade), or it may be a group of components (e.g. drive train).

In some examples, the part of the wind turbine for which the dynamic properties are determined is the drive train or a portion of the drive train. Because of the integration of the generator in the drive train, such a method is particularly suited e.g. for determining dynamic properties of a drive train of a wind turbine.

The shifts in dynamic properties of a wind turbine during its lifetime may indicate a series of faults or structural changes. In some examples, a method for determining presence of a fault may comprise periodically repeating a method according to the present invention, and determining the presence of a fault if the dynamic properties of the drive train change significantly. Detecting the existence of a possible fault with the proposed method will contribute to a proper monitoring of the turbine, without a need to stop operation. Since the input signal generated by the converter can be applied to the generator as a superimposed signal during normal operation of the wind turbine, energy production does not need to be affected. Furthermore, the proposed method avoids the need to perform tests manually on the turbine in order to detect the fault.

In some examples, a method for determining a fault may comprise calculating one or more theoretical dynamic properties of a part of a wind turbine prior to assembly of the wind turbine, determining one or more dynamic properties of the system after assembly of the wind turbine with a method according to the present disclosure, and comparing the dynamic properties of the part of the wind turbine to the theoretical dynamic properties. A difference between the theoretical and the actual dynamic properties may allow for detecting faults in the assembly of the turbine, and/or re-establishing the reference parameters for said turbine's drive train by comparing them.

In yet a further example, generating a fault register may comprise introducing a perturbation in the part of the wind turbine (e.g. the drive train) prior to generating an input signal by the converter, performing a method according to the present disclosure, and thereafter storing the dynamic properties of the part in relation to the perturbation. Such a perturbation may e.g. be a fault in a flexible coupling of a rotor shaft or a coupling between rotor and generator, a weight imbalance or other. By generating a fault register after recording a series of dynamic properties directly correlated to the introduced perturbations, an eventual diagnosis may be performed based on such register during operation. If dynamic properties during operation substantially coincide with those belonging to a certain fault, a proper diagnosis can be made.

Additional objects, advantages and features of embodiments of the invention will become apparent to those skilled in the art upon examination of the description, or may be learned by practice of the invention.

### BRIEF DESCRIPTION OF THE DRAWINGS

Non-limiting examples of the present disclosure will be described in the following, with reference to the appended drawings, in which:
Figure 1 schematically illustrates an example of a drivetrain of a direct drive wind turbine;
Figure 2a illustrates a flow diagram of an example of a method for determining dynamic properties;
Figure 2b illustrates an example of a sweep sine input signal which may be used in examples of methods for determining dynamic properties;
Figure 2c illustrates an example of an output signal that may be obtained in examples of methods for determining dynamic properties; and
Figure 3 illustrates an example of a fault detection method.

### DETAILED DESCRIPTION

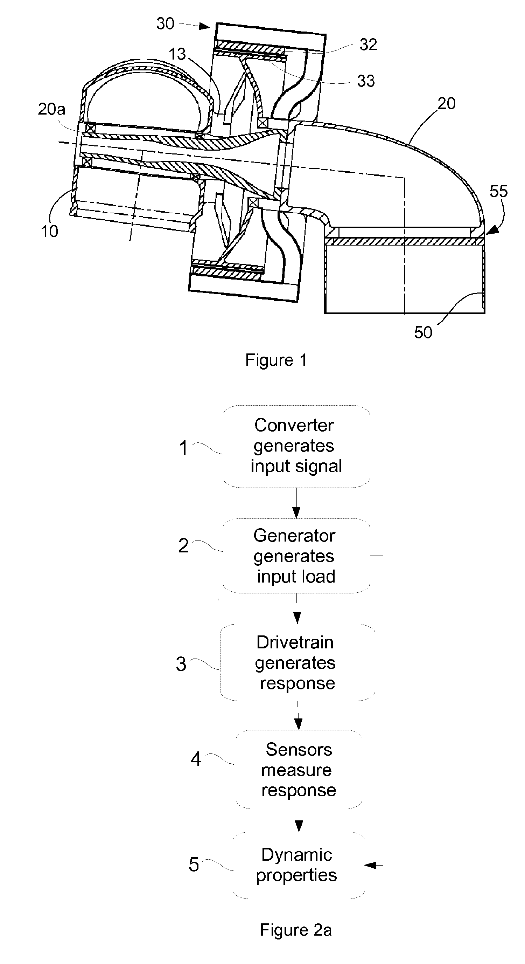

Figure 1 illustrates schematically an example of a direct drive wind turbine. Wind turbine 1 comprises a hub 10 carrying a plurality of blades (not shown). The roots of the blades are directly attached at the hub. Hub 10 is rotatably mounted on a front frame 20a. A generator 30 is also mounted upon the front frame 20a. The generator 30 comprises a generator stator 32 and a generator rotor 33. Also shown schematically in figure 1 is wind turbine tower 50. A coupling body 13 is attached to hub 10. Reference sign 55 indicates the presence of a yaw mechanism allowing rear frame 20 to rotate with respect to the tower's longitudinal axis.

The generator may be a permanent magnet generator. The wind turbine of figure 1 may be an offshore wind turbine. In the sort of configuration depicted in figure 1, prior art shaker and hammer test mechanisms may be particularly difficult to be implemented, because of the high frequencies and energies needed to excite the drive train. For instance, hammer tests are run on a drive train that is not locked (wind turbine operational conditions), which implies risks for workers performing the tests.

Figure 2a is an illustration of a flow diagram describing an example of a method for determining dynamic properties of a drive train of a wind turbine.

At block 1, a converter sending an input signal to the generator to create a corresponding input load may be provided. The input signal may be e.g. an oscillating signal (e.g., sinusoidal, sweep sine, chirp signal) or a random noise signal.

One advantage of the converter inducing the input signal through the generator is that no extra elements need to be added to or operated upon in the wind turbine.

At block 2, an input load may be provided by the generator which may cause the drive train to vibrate. The generator is driven to do so by the input signal sent by the converter. The input load may comprise an oscillating torque.

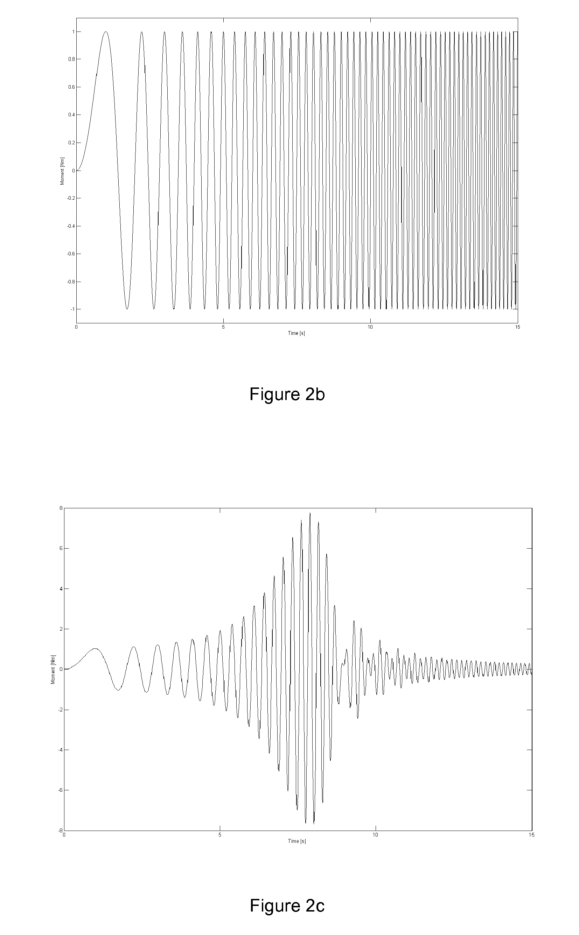

Figure 2b schematically illustrates an oscillating input signal, in particular a sweep sine signal. A sweep sine is a sinusoidal wave signal in which the frequency increases or decreases with time. For example, this type of input may allow detecting at which point the drive train vibrations increase significantly and thus to determine its natural frequency of vibration, which can be one of the dynamic properties the method aims to determine.

At block 3, the drive train, after receiving the input load, may generate a response which may be a vibration or an output torque. Said response is the one that permits characterising the drive train, i.e., determining its dynamic properties, after being measured at the structural parts taken into consideration.

An example of an output signal that may be obtained in such methods is shown in figure 2c. The area of the signal where the maximum vibration amplitude is achieved indicates the natural frequency of the drivetrain. According to the output and input amplitudes, the transmissibility and hence the corresponding damping values may be estimated.

At block 4 the response may be measured by sensors. Said sensors may be for instance strain gauges. A strain gauge takes advantage of the physical property of electrical conductance and its dependence on the conductor's geometry. The strain gauge measures the deformation (strain) as a change in electrical resistance, which is a measure of the strain and hence the applied forces. A load cell usually consists of four strain gauges in a Wheatstone bridge configuration. Load cells of one strain gauge (quarter bridge) or two strain gauges (half bridge) are also available. Another type of sensors may include accelerometers. Accelerometers are frequently used to detect and monitor vibration in rotating machinery.

The sensors may be arranged at any suitable location in the drive train. For example, the accelerometers or strain gauges may be arranged at the coupling arms to measure the response from the drive train. An example of such coupling arms is shown in Figure 1, which illustrates a particular drive train configuration, namely a direct drive turbine wherein the hub is rotatably mounted on a frame. The coupling body 13 substantially comprises a plate with a plurality of substantially radially extending spokes. The distal ends of these spokes protrude into a generator rotor carrying structure and are connected to this carrying structure through flexible elements.

A suitable position for placing sensors such as strain gauges and/or accelerometers would be the spokes of the coupling body 13 in the example of figure 1. At this location, e.g. movements of the generator with respect to the rotor may be registered.

In this sense, the mentioned "flexible couplings" are to be understood to be couplings that yield ("give in") relatively easily under loads. They may be made from any suitable material, e.g. elastic or elastomer materials. The couplings may obtain their flexible properties due to their shape, material, positioning, mounting or combinations of these. The flexible elements may comprise a hydraulic circuit through which the stiffness of the elements can be controlled.

Preferably, strain gauges may be arranged in the rotating part of the turbine. However, they may also be positioned at the tower, depending on the part that is to be analysed.

Even though the input load is first directly introduced into the drive train, the input load is indirectly introduced to other parts as well, since it will be transmitted to non-rotating parts such as the tower or even a substructure. A response will therefore also be excited in these other parts. By suitably placing sensors, the response in parts or components of the wind turbine that are of interest could be measured. For example, the response of a blade could be measured or the response of the tower. Again, if the output signal (movements, loads) is known, the dynamic properties can be determined since the input loads are also known.

At block 5, the dynamic properties of the drive train may be determined from the measured response and the input signal fed in by the generator.

As mentioned above, from all measurements of the drive train responses to one or more inputs, dynamic properties may be determined including e.g. the modal frequencies, and/or modal masses, and/or modal damping ratios and/or mode shapes of the drive train.

Examples of the methods hereinbefore described may be applicable to any type of wind turbine. In the previous example, an application to a specific configuration of a direct drive wind turbine was explained. However, the methods can also be advantageously applied in drive trains including a gearbox.

Some of the possible applications of the determination of the dynamic properties of a wind turbine are explained in the following examples.

One possible method is to determine the presence of a fault. The method may comprise running a modal testing on a periodical basis, i.e., repeating the method according to the disclosure periodically, thus determining if the dynamic properties of the part of the wind turbine have suffered significant changes over time. Significant changes may indicate the presence of a fault.

This method may for example be applied to detect damage, and to issue warnings. The vibrational spectra of the rotor blades may be determined and compared with reference spectra. A shift of the typical frequencies in the spectrum usually takes place, for example, with changes in the material properties, such as a change in the modulus of elasticity or density, or by damage or changes in the rotor blade. Thus, it is possible to make timely countermeasures such as repairs, before damage occurs.

Mechanical influences like ice formation and damage to the surface of the rotor blade, such as cracks or flaking (spalling), may negatively influence the profile geometry of the rotor blade. Such effects might also be recognized at a fault detection testing of rotor blades.

This means that, *inter alia*, natural frequency shifts and changes in other modal properties of the rotor blades, which indicate state changes, may be detected faster and at a lower cost than in external shaking based methods, while keeping accuracy.

With the aim to detect such shifts, the dynamic properties of the wind turbine can be determined after assembling and/or installation, as well as periodically during the turbine's lifetime.

It should be noted that this method may not always give information on what exactly the fault is, or the original cause of it. Nevertheless, further methods based on this one, as described on the following, can at least partly provide such information.

An alternative method for determining a fault may comprise, firstly, calculating the theoretical dynamic properties of the drive train prior to assembly of the wind turbine. Secondly, after assembly of the wind turbine, the same dynamic properties of the system may be determined with the method according to the present disclosure. Finally, the dynamic properties of the drive train may be compared to the theoretical dynamic properties. The comparison thus may yield any changes in the system characterisation as compared to the design-operational parameters. Moreover, checking the system response to an input signal may allow for detecting abnormalities. During the manufacturing or assembly process some issues might arise (e.g., loose fastening of anchor bolts, bearing malfunction, or incorrect elastomer-hydraulic pressure in the flexible coupling described before with respect to figure 1). Therefore, the method may be an advantageous tool when performing a Factory Acceptance Test (FAT) of a Rotor Nacelle Assembly.

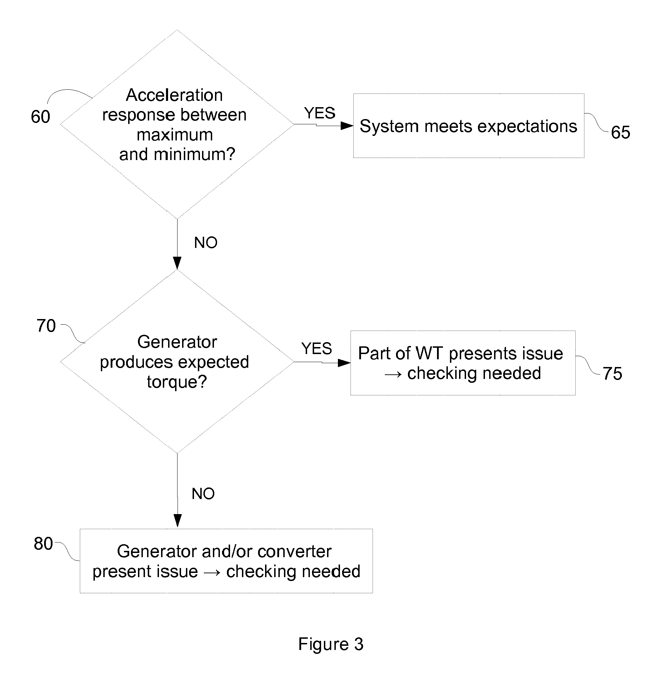

Figure 3 illustrates a flow diagram on an example of application of the method to a FAT. After an input signal has been generated by the converter, at block 60 the system checks if the acceleration response lies between a maximum and minimum value - both values pre-set according to the expected results for the system-. If the answer is yes, the process ends at block 65 because the system meets the expectations. Otherwise, the process continues at block 70, where the system checks if the generator produces the expected torque according to its design parameters. If the answer is yes, the process ends at block 75, because the generator is functioning correctly and the attained information yields that a part of the wind turbine system needs further checking. This is because the part might present some issue which has altered the block 60 test results. Otherwise, the process continues at block 80, leading to the conclusion that the generator and/or the converter might be the ones presenting an issue instead, and therefore further checking of these elements is necessary.

Yet a further alternative is a method for generating a fault register. In order to develop a diagnosis tool that offers a possible meaning to detected variations in the dynamic properties, this method may provide a way to explore and register the consequences of faults in terms of dynamic properties variations. The method may comprise introducing a perturbation or fault in a part of a wind turbine in a controlled manner. The system perturbation may be a mechanical fault (e.g., loose fastening of bolts, or a wrong setting of the aforementioned hydraulic pressure, blade issues) and/or an electronic fault. Afterwards, an input signal may be generated by the converter, and the dynamic properties may be determined with any of the methods according to the present disclosure. These resulting dynamic properties of the part may be stored in the register in relation to the perturbation introduced previously. Further analysis and statistical treatment of collected data may result in a fault register which may help foreseeing, detecting and/or diagnosing events during, for instance, the later periodical modal testing of the wind turbine.

Although only a number of examples have been disclosed herein, other alternatives, modifications, uses and/or equivalents thereof are possible. Furthermore, all possible combinations of the described examples are also covered. Thus, the scope of the present disclosure should not be limited by particular examples, but should be determined only by a fair reading of the claims that follow.

## Claims

1. A method for determining one or more dynamic properties of a part of a wind turbine, the wind turbine including a wind turbine rotor including a rotor hub and one or more blades, a generator operatively coupled to the rotor, and a converter connected to the generator,
the method comprising:
the converter sending an input signal to the generator to create an input load;
measuring a response from the part of the wind turbine under the input load with one or more sensors; and
determining one or more dynamic properties of the part from the response of the part and the input load.

2. A method according to claim 1, wherein the part of a wind turbine is the drive train.

3. A method according to any of claims 1 - 2, wherein the input load comprises a torque.

4. A method according to claim 3, wherein the input load includes an oscillating torque.

5. A method according to claim 4 wherein the input signal is a sinusoidal signal, or a sweep sine signal.

6. A method according to any of claims 1 - 3, wherein the input signal is a random noise signal.

7. A method according to any of claims 1 - 6, wherein the sensors include strain gauges and/or accelerometers.

8. A method according to any of claims 1 - 7, wherein the wind turbine is a direct drive wind turbine.

9. A method according claim 8, wherein a rotor of the generator is directly coupled to the wind turbine rotor with a coupling having a plurality of coupling arms, the coupling arms having strain gauges and/or accelerometers to measure the response from the drive train.

10. A method according to any of claims 1 - 9, wherein the rotor is rotating when creating an input load.

11. A method according to any of claims 1 - 10, wherein determining dynamic properties of the part of the wind turbine comprises determining modal frequencies of the part.

12. A method according to any of claims 1 - 11, wherein determining dynamic properties of the part of the wind turbine further comprises determining modal masses, and/or modal damping ratios and/or mode shapes.

13. A method for determining presence of a fault, comprising
periodically repeating a method according to any of claims 1 - 12, and
determining the presence of a fault if the dynamic properties of the part of the wind turbine change significantly.

14. A method for determining a fault, comprising:
calculating one or more theoretical dynamic properties of a part of a wind turbine prior to assembly of the wind turbine;
determining one or more dynamic properties of the part after assembly of the wind turbine with a method according to any of claims 1 - 13; and
comparing the dynamic properties of the part to the theoretical dynamic properties.

15. A method for generating a fault register, comprising
introducing a perturbation in a wind turbine part prior to generating an input signal by the converter;
performing a method according to any of claims 1 - 13; and storing the dynamic properties of the drive train in relation to the perturbation.
